# EUROPEAN PATENT APPLICATION

(11) **EP 4 593 063 A1**
(43) Date of publication of application: **30.07.2025**
(21) Application number: 25152823.8
(22) Date of filing: 20.01.2025
(51) Int. Cl.: H01L 21/32, H10B 12/00

(54) **METHOD OF PROCESSING SUBSTRATE, METHOD OF MANUFACTURING SEMICONDUCTOR DEVICE, PROGRAM, AND SUBSTRATE PROCESSING APPARATUS**

(30) Priority: 23.01.2024 JP 2024007779
(71) Applicant: Kokusai Electric Corporation, Tokyo 101-0045 (JP)
(72) Inventor: NAKATANI, Kimihiko, Toyama-shi, Toyama 939-2393 (JP); HASHIMOTO, Yoshitomo, Toyama-shi, Toyama 939-2393 (JP)
(74) Representative: Bardehle Pagenberg Partnerschaft mbB Patentanwälte Rechtsanwälte

(57) **Abstract**

There is provided a technique that includes (a) in a substrate (200) including a structure where respective surfaces of a first material, a second material, and a third material are adjacent to each other in that order, forming a first dielectric film containing oxygen on the surface of the first material and a second dielectric film containing oxygen on the surface of the third material, each of the first dielectric film and the second dielectric film being formed selectively with respect to the surface of the second material; and (b) forming a separation film inside a recess with a sidewall defined by the first dielectric film and the second dielectric film.

## Description

### CROSS-REFERENCE TO RELATED APPLICATION

This application is based upon and claims the benefit of priority from Japanese Patent Application No. 2024-007779, filed on January 23, 2024, the entire contents of which are incorporated herein by reference.

### TECHNICAL FIELD

The present disclosure relates to a method of processing a substrate, a method of manufacturing a semiconductor device, a program, and a substrate processing apparatus.

### BACKGROUND

As a process of manufacturing semiconductor devices, a process of forming a film on a surface of a substrate may be performed.

### SUMMARY

Some embodiments of the present disclosure provide a technique capable of precisely forming a film on a substrate.

According to embodiments of the present disclosure, there is provided a technique that includes (a) in a substrate including a structure where respective surfaces of a first material, a second material, and a third material are adjacent to each other in this order, forming a first dielectric film containing oxygen on the surface of the first material and a second dielectric film containing oxygen on the surface of the third material, each of the first dielectric film and the second dielectric film being formed selectively with respect to the surface of the second material; and (b) forming a separation film inside a recess with a sidewall defined by the first dielectric film and the second dielectric film.

### BRIEF DESCRIPTION OF DRAWINGS

The accompanying drawings, which are incorporated in and constitute a part of the specification, illustrate embodiments of the present disclosure.
FIG. 1 is a schematic configuration diagram of a vertical process furnace of a substrate processing apparatus suitably used in embodiments of the present disclosure, illustrating a portion of the process furnace in a vertical cross-sectional view.
FIG. 2 is a schematic configuration diagram of the vertical process furnace of the substrate processing apparatus suitably used in embodiments of the present disclosure, illustrating a portion of the process furnace in a cross-sectional view taken along line A-A in FIG. 1.
FIG. 3 is a schematic configuration diagram of a controller of the substrate processing apparatus suitably used in embodiments of the present disclosure, illustrating a control system of the controller in a block diagram.

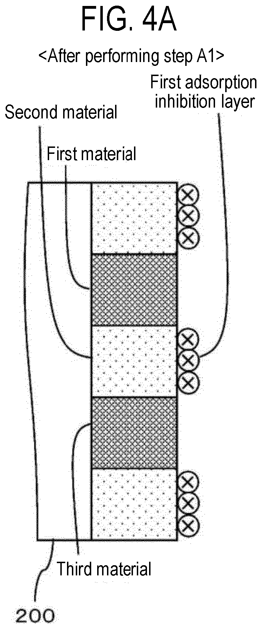

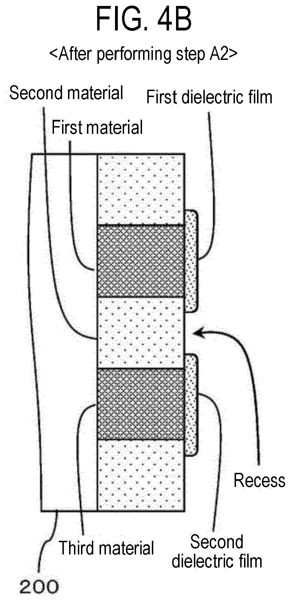

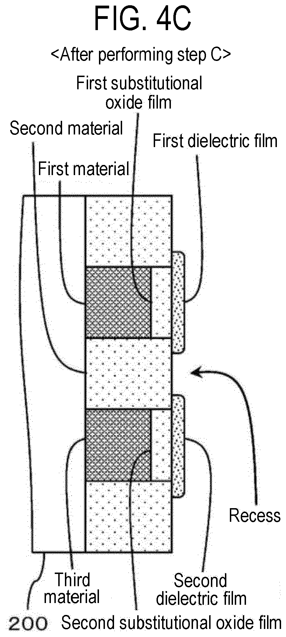

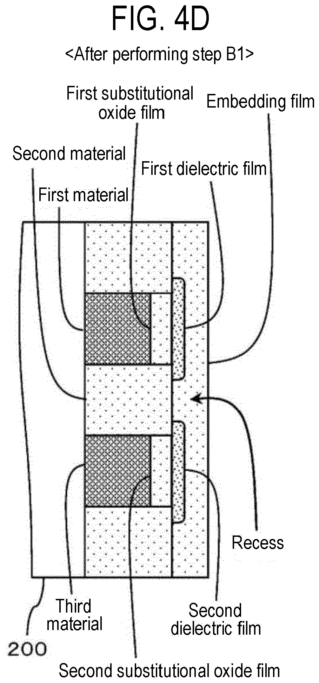

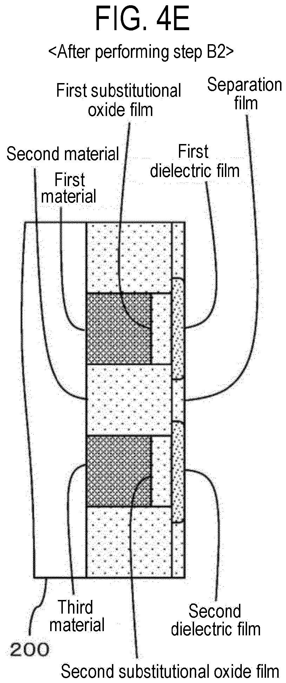

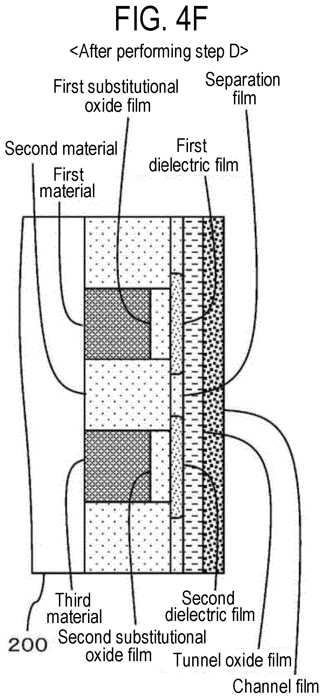

FIG. 4A is a partially enlarged cross-sectional view illustrating a surface portion of a wafer in embodiments of the present disclosure after performing step A1 in which a first adsorption inhibition layer is formed on a surface of a second material. FIG. 4B is a partially enlarged cross-sectional view illustrating a surface portion of the wafer in embodiments of the present disclosure after performing, in the state of FIG. 4A, step A2 in which a first dielectric film is formed on a surface of a first material and a second dielectric film is formed on a surface of a third material. FIG. 4C is a partially enlarged cross-sectional view illustrating a surface portion of the wafer in embodiments of the present disclosure after performing, in the state of FIG. 4B, step C in which a portion of the first material is modified into a first substitutional oxide film and a portion of the third material is modified into a second substitutional oxide film. FIG. 4D is a partially enlarged cross-sectional view illustrating a surface portion of the wafer in embodiments of the present disclosure after performing, in the state of FIG. 4C, step B1 in which an embedding film is formed on the wafer. FIG. 4E is a partially enlarged cross-sectional view illustrating a surface portion of the wafer in embodiments of the present disclosure after performing, in the state of FIG. 4D, step B2 in which a portion of the embedding film is removed and a separation film is formed on the wafer. FIG. 4F is a partially enlarged cross-sectional view illustrating a surface portion of the wafer in embodiments of the present disclosure after performing, in the state of FIG. 4E, step D in which a tunnel oxide film and a channel film are sequentially stacked on the wafer.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

### <Embodiments of Present Disclosure>

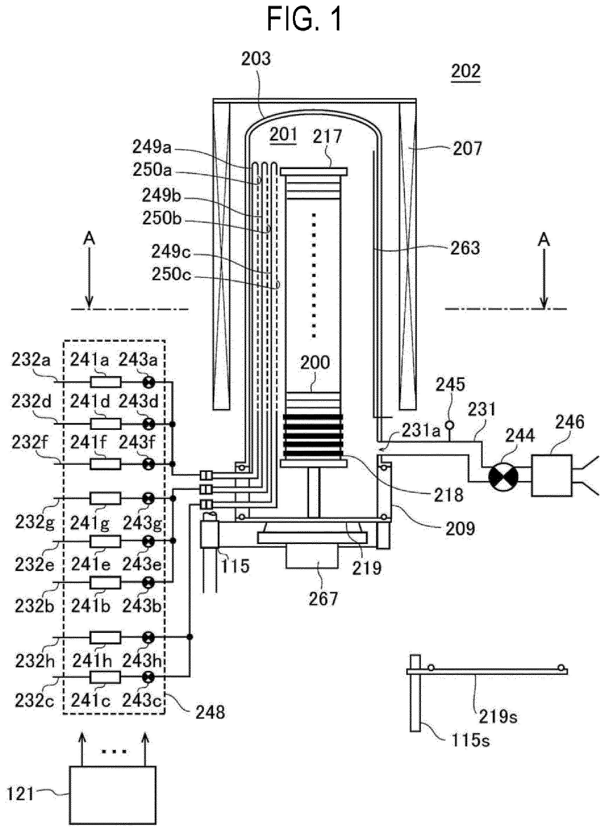

Hereinafter, embodiments of the present disclosure are described mainly with reference to FIGS. 1 to 3 and FIGS. 4A to 4F. In addition, the drawings used in the following description are schematic, and dimensional relationships between respective components and proportions of respective components illustrated in the drawings may not correspond to those in reality. Further, the dimensional relationships between respective elements and the proportions of respective elements may not match among multiple drawings.

### (1) Configuration of Substrate Processing Apparatus

As illustrated in FIG. 1, a process furnace 202 of a substrate processing apparatus includes a reaction tube 203. A manifold 209 is disposed below the reaction tube 203. A process container mainly includes the reaction tube 203 and the manifold 209. A process chamber 201 is formed in an interior of the process container. The process chamber 201 is configured to be capable of accommodating a wafer 200, which serves as a substrate.

A heater 207 is installed at an exterior of the reaction tube 203 to heat the wafer 200 inside the process chamber 201. The heater 207 also functions as an activator that activates gases inside the process chamber 201 with heat. A temperature sensor 263 is installed inside the reaction tube 203.

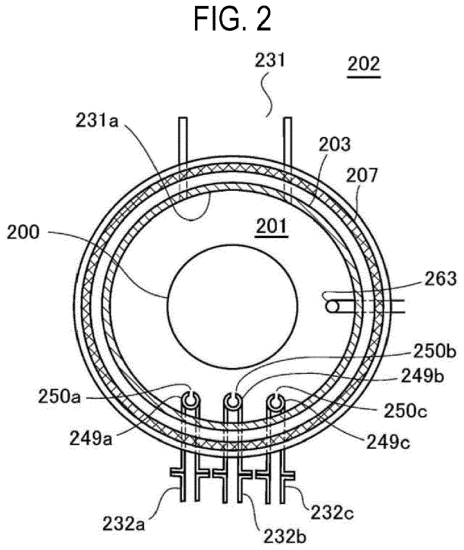

Nozzles 249a to 249c are installed inside the process chamber 201. As illustrated in FIG. 2, the nozzles 249a to 249c are installed to stand upright along an inner wall of the reaction tube 203 in an arrangement direction of the wafer 200. A plurality of gas supply holes 250a to 250c are provided on sides of the nozzles 249a to 249c from a bottom to a top of the reaction tube 203.

Gas supply pipes 232a to 232c are connected to the nozzles 249a to 249c. The gas supply pipes 232a to 232c are installed with mass flow controllers (MFCs) 241a to 241c and valves 243a to 243c. Gas supply pipes 232d and 232f are connected to the gas supply pipe 232a at a downstream of the valve 243a. Gas supply pipes 232e and 232g are connected to the gas supply pipe 232b at a downstream of the valve 243b. A gas supply pipe 232h is connected to the gas supply pipe 232c at a downstream of the valve 243c. The gas supply pipes 232d to 232h are installed with MFCs 241d to 241h and valves 243d to 243h.

A first precursor is supplied from the gas supply pipe 232a into the process chamber 201 through the MFC 241a, valve 243a, and nozzle 249a.

A reactant (oxidizing agent) is supplied from the gas supply pipe 232b into the process chamber 201 through the MFC 241b, valve 243b, and nozzle 249b.

A modifying agent is supplied from the gas supply pipe 232c into the process chamber 201 through the MFC 241c, valve 243c, and nozzle 249c.

A second precursor is supplied from the gas supply pipe 232d into the process chamber 201 through the MFC 241d, valve 243d, gas supply pipe 232a, and nozzle 249a.

A catalyst is supplied from the gas supply pipe 232e into the process chamber 201 through the MFC 241e, valve 243e, gas supply pipe 232b, and nozzle 249b.

An inert gas is supplied from the gas supply pipes 232f to 232h into the process chamber 201 through the MFCs 241f to 241h, valves 243f to 243h, gas supply pipes 232a to 232c, and nozzles 249a to 249c. The inert gas acts as a purge gas, carrier gas, dilution gas, and others.

A first precursor supply system mainly includes the gas supply pipe 232a, MFC 241a, and valve 243a. A reactant (oxidizing agent) supply system mainly includes the gas supply pipe 232b, MFC 241b, and valve 243b. A modifying agent supply system mainly includes the gas supply pipe 232c, MFC 241c, and valve 243c. A second precursor supply system mainly includes the gas supply pipe 232d, MFC 241d, and valve 243d. A catalyst supply system mainly includes the gas supply pipe 232e, MFC 241e, and valve 243e. An inert gas supply system mainly includes the gas supply pipes 232f to 232h, MFCs 241f to 241h, and valves 243f to 243h. Any of or the entire various supply systems described above may be configured as an integrated supply system 248 where the valves 243a to 243h, MFCs 241a to 241h, and others are integrated. In addition, if different reactants are used in respective process steps (steps A, B and C) to be described later, a reactant supply system that supplies a reactant to the nozzle 249b is individually installed for each different reactant.

An exhaust port 231a is installed below the reaction tube 203. A vacuum pump 246 is connected to an exhaust pipe 231 through a pressure sensor 245 and an auto pressure controller (APC) valve 244. An exhaust system mainly includes the exhaust pipe 231, APC valve 244, and pressure sensor 245. The vacuum pump 246 may also be included in the exhaust system.

A seal cap 219 is installed below the manifold 209. A rotator 267 that rotates a boat 217 to be described later is installed to the seal cap 219. The seal cap 219 is raised or lowered by a boat elevator 115. The boat elevator 115 functions as a transfer mechanism that transfers the wafer 200 into and out of the process chamber 201.

A shutter 219s capable of hermetically closing an opening at a lower end of the manifold 209 is installed below the manifold 209. The opening/closing operation of the shutter 219s is controlled by a shutter opening/closing mechanism 115s.

The boat 217, which serves as a substrate support, is configured to support a plurality of wafers 200, e.g., 25 to 200 wafers, in such a state that the wafers 200 are arranged in a horizontal posture and in multiple stages along a vertical direction with centers of the wafers 200 aligned with one another. Heat insulation plates 218 are supported in multiple stages at a lower portion of the boat 217.

Furthermore, the substrate processing apparatus may include an etching unit (etching device) that performs step B2 (separation film formation) to be described later. This unit includes, for example, an etching gas supply system that supplies an etching gas into the process container accommodating the wafer 200, a plasma generator that excites the etching gas inside the process container into a plasma by an electrode (antenna) supplied with radio frequency power, a bias regulator that regulates a potential (bias) of the wafer 200. In step B2, anisotropic plasma etching may be performed on the wafer 200 by using this unit.

In addition, the substrate processing apparatus including the etching unit may be configured as a processing system connected to each other via a communication network.

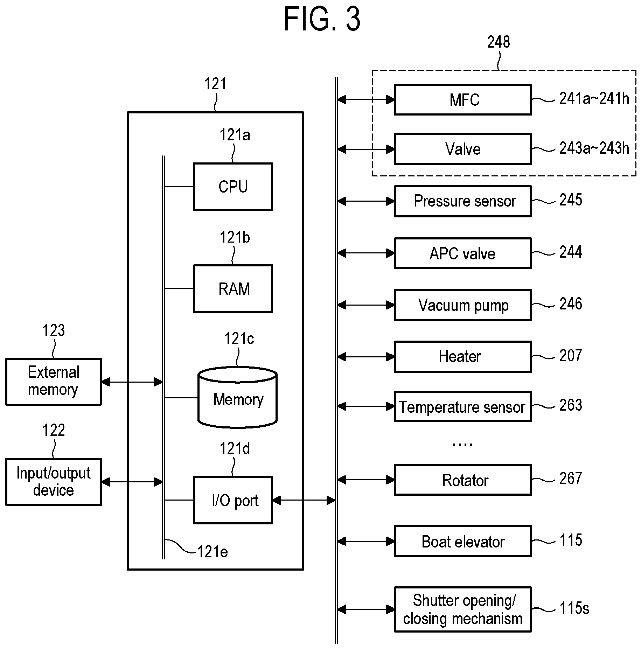

As illustrated in FIG. 3, the controller 121, which serves as a control part, is configured as a computer including a CPU (Central Processing Unit) 121a, RAM (Random Access Memory) 121b, memory 121c, and I/O port 121d. The RAM 121b, memory 121c, and I/O port 121d are configured to be capable of exchanging data with the CPU 121a through an internal bus 121e. The controller 121 is connected to an input/output device 122, which is formed of, for example, a touch panel and the others. An external memory 123 may also be connected to the controller 121.

The memory 121c is composed of a flash memory, HDD (Hard Disk Drive), SSD (Solid State Drive), and others. The memory 121c records and stores, in a readable manner, a control program that controls the operation of the processing apparatus, a process recipe that describes procedures, conditions, and others for substrate processing to be described later, and others. The process recipe is a combination that causes the controller 121 to execute each procedure of substrate processing to be described later in the processing apparatus to achieve predetermined results. The process recipe functions as a program. Hereinafter, the process recipe, the control program and the like are collectively referred to simply as "program." Further, the process recipe is also simply referred to as "recipe." The term "program" as used herein may include a case of solely including the recipe, a case of solely including the control program, or a case of including both the recipe and the control program.

The I/O port 121d is connected to the MFCs 241a to 241h, valves 243a to 243h, pressure sensor 245, APC valve 244, vacuum pump 246, temperature sensor 263, heater 207, rotator 267, boat elevator 115, shutter opening/closing mechanism 115s, and others. The I/O port 121d may also be connected to the etching unit.

The CPU 121a is configured to be capable of reading and executing the control program from the memory 121c, and reading the recipe from the memory 121c in response to an input such as an operation command from the input/output device 122. The CPU 121a is configured to be capable of controlling, according to contents of the recipe thus read, the regulating operations of the flow rates of various substances by the MFCs 241a to 241h, the opening/closing operations of the valves 243a to 243h, the opening/closing operation of the APC valve 244, the pressure regulating operation by the APC valve 244 based on the pressure sensor 245, the startup and shutdown of the vacuum pump 246, the temperature regulating operation of the heater 207 based on the temperature sensor 263, the rotation and rotational speed adjusting operation of the boat 217 by the rotator 267, the raising and lowering operation of the boat 217 by the boat elevator 115, the opening/closing operation of the shutter 219s by the shutter opening/closing mechanism 115s, and others. The CPU 121a may also be configured to be capable of controlling the etching unit.

The controller 121 may be configured by installing the aforementioned program, which is recorded and stored in the external memory 123, onto the computer. The external memory 123 includes a magnetic disk such as a HDD or the like, an optical disk such as a CD or the like, a magneto-optical disk such as a MO or the like, a semiconductor memory such as a USB memory, a SSD, or the like, and so forth. The memory 121c and the external memory 123 are configured as computer-readable recording media. Hereinafter, the memory 121c and the external memory 123 are collectively referred to simply as "recording medium." The term "recording medium" as used herein may refer to a case of solely including the memory 121c, a case of solely including the external memory 123, or a case of including both. The provision of the program to the computer may be carried out using a communication facility such as the Internet.

### (2) Substrate Processing Process

An example of processing sequences for forming films on a surface of the wafer 200, which serves as a substrate, by using the above-described substrate processing apparatus is described mainly with reference to FIGS. 4A to 4F as one of manufacturing processes (manufacturing methods) of semiconductor devices. Some steps (steps A1, A2, C and B1) of a series of processing sequences illustrated below are carried out by the above-described substrate processing apparatus. In this case, the operation of each component constituting the substrate processing apparatus is controlled by the controller 121.

In the process sequences of the present embodiments, the following steps are performed:
(a) step A in which, in the wafer 200 including a structure where respective surfaces of a first material, a second material, and a third material are adjacent to each other in this order, a first dielectric film containing oxygen is formed on the surface of the first material and a second dielectric film containing oxygen is formed on the surface of the third material, each of the first dielectric film and the second dielectric film being formed selectively with respect to the surface of the second material; and
(b) step B in which a separation film is formed inside a recess with sidewalls defined by the first dielectric film and the second dielectric film.

In addition, in the following example, a description is given of a case where step A includes the following steps, as illustrated in FIGS. 4A and 4B:
(a-1) step A1 in which a first adsorption inhibition layer that inhibits adsorption of a first precursor is formed on the surface of the second material, selectively with respect to the surface of each of the first and third materials; and
(a-2) step A2 in which the first precursor is supplied to the wafer 200, thereby forming the first dielectric film on the surface of the first material and the second dielectric film on the surface of the third material, respectively.

Further, in the following example, a description is given of a case where, after performing step A, as illustrated in FIG. 4C, step C is also performed in which, by supplying an oxidizing agent to the wafer 200, a portion of the first material in contact with an interface between the first material and the first dielectric film is modified into a first substitutional oxide film through the first dielectric film, and a portion of the third material in contact with an interface between the third material and the second dielectric film is modified into a second substitutional oxide film through the second dielectric film. In addition, in the following example, a description is given of a case where step C is performed before performing step B.

Further, in the following example, a description is given of a case where step B includes the following steps, as illustrated in FIGS. 4D and 4E:
(b-1) step B1 in which an embedding film is formed to fill the recess and cover at least a portion of an upper surface of each of the first dielectric film and the second dielectric film; and
(b-2) step B2 in which a portion of the embedding film formed inside the recess is left as a separation film while removing the other portion.

Further, in the following example, a description is given of a case where, after performing Step B, as illustrated in FIG. 4F, step D is also performed in which a tunnel oxide film and a channel film are sequentially stacked on the surface of the wafer 200, i.e., on a surface of each of the separation film, the first dielectric film, and the second dielectric film, formed on the wafer 200.

The term "wafer" as used herein may refer to a wafer itself, or a stacked body including the wafer and a predetermined layer or film formed on a surface of the wafer. The term "a surface of the wafer" as used herein may refer to the surface of the wafer itself, or a surface of a predetermined layer formed on the wafer. If it is stated herein "a predetermined layer is formed on the surface of the wafer", it may mean that the predetermined layer is directly formed on the surface of the wafer itself, or that the predetermined layer is formed on a layer or the like formed on the wafer. The term "substrate" as used herein is synonymous with the term "wafer."

The terms "agent" and "substance" as used herein include at least one selected from the group of gaseous substances and liquid substances. The liquid substance includes mist-like substances. In other words, each of the modifying agent, first to third precursors, and reactant (oxidizing agent and nitriding agent) may include a gaseous substance, may include a liquid substance such as mist-like substance, or may include both.

Hereinafter, the processing sequences of the present embodiments are specifically described.

When a plurality of wafers 200 are charged onto the boat 217 (wafer charging), the shutter 219s is moved, so that the opening at the lower end of the manifold 209 is opened (shutter opening). Thereafter, the boat 217 supporting the plurality of wafers 200 is lifted by the boat elevator 115 and is loaded into the process chamber 201 (boat loading).

The wafer 200, which is a processing target, includes a structure (hereinafter, also referred to as "adjacent structure") on its surface where the respective surfaces of the first material, the second material, and the third material are adjacent to each other in this order, as illustrated in FIG. 4A and others. The respective surfaces of the first material, the second material, and the third material are formed on a same plane. The surface of the wafer 200 may include three-dimensional structures such as trenches and holes, and the aforementioned adjacent structure may be provided on three-dimensional portions such as sidewall surfaces of the trenches and holes. Further, the aforementioned adjacent structure may also be provided on a flat portion of the surface of the wafer 200. The second material may be an oxide, while the first material and the third material may each be at least one selected from the group of an oxide with a lower oxygen content ratio (i.e., a ratio of oxygen in a material composition or an oxygen concentration) than that of the second material, and a non-oxide. For example, the first material and the third material may each be a nitride such as silicon nitride (SiN), while the second material may be an oxide such as silicon oxide (SiO). Further, the first material and the third material may each be a material in which at least a portion of a surface of a non-oxide such as SiN is naturally oxidized. Even in this case, the naturally oxidized surface is lower in an oxygen content ratio than that of the second material.

After the boat loading is completed, the interior of the process chamber 201 is vacuum-exhausted (decompression-exhausted) by the vacuum pump 246 to reach a desired pressure (degree of vacuum). Further, the wafers 200 inside the process chamber 201 are heated by the heater 207 to reach a desired processing temperature. Further, the rotation of the wafers 200 is initiated by the rotator 267. The vacuum exhaust of the process chamber 201 and the heating and rotation of the wafers 200 continue at least until the wafers 200 are completely processed.

### (Step A)

Next, the following steps A1 and A2 are performed on the wafer 200 prepared inside the process chamber 201.

### [Step A1: Formation of First Adsorption Inhibition Layer]

In this step, the valve 243c is opened to supply a modifying agent (inhibitor) to the wafer 200. At this time, the valves 243f to 243h may be opened to supply an inert gas into the process chamber 201.

By performing step A1 under processing conditions to be described later, as illustrated in FIG. 4A, a first adsorption inhibition layer (first inhibitor layer) that inhibits adsorption of the first precursor may be formed on the surface of the second material, selectively with respect to the surface of each of the first material and the third material. The first adsorption inhibition layer contains at least a portion of molecular structures of molecules constituting the modifying agent. In the present disclosure, the phrase "selectively forming the first adsorption inhibition layer on the surface of the second material" does not mean "forming the first adsorption inhibition layer solely on the surface of the second material" but rather means "forming the first adsorption inhibition layer preferentially on the surface of the second material, among the respective surfaces of the first, second, and third materials." In other words, this phrase does not completely exclude formation of the first adsorption inhibition layer on the surface of the first material or the formation of the first adsorption inhibition layer on the surface of the third material. The term "selectively" is used in a similar sense in each of the following steps.

After selectively forming the first adsorption inhibition layer on the surface of the second material, the valve 243c is closed to stop the supply of the modifying agent to the wafer 200. Then, the interior of the process chamber 201 is vacuum-exhausted, and gaseous substances and others remaining inside the process chamber 201 are removed from the interior of the process chamber 201. Further, the valves 243f to 243h are opened, an inert gas is supplied into the process chamber 201, and the interior of the process chamber 201 is purged (purging).

For example, alkylaminosilanes such as (dimethylamino)trimethylsilane ((CH₃)₂NSi(CH₃)₃), (diethylamino)triethylsilane ((C₂H5)₂NSi(C₂H₅)₃), (dimethylamino)triethylsilane ((CH₃)₂NSi(C₂H₅)₃), (diethylamino)trimethylsilane ((C₂H₅)₂NSi(CH₃)₃), (dipropylamino)trimethylsilane((C₃H₇)₂NSi(CH₃)₃), or the like may be used as the modifying agent.

Further, for example, aminosilanes such as tetrakis(dimethylamino)silane (Si[N(CH₃)₂]₄), tris(dimethylamino)silane (Si[N(CH₃)₂]₃H), bis(diethylamino)silane (Si[N(C₂H₅)₂]₂H₂), bis(tert-butylamino)silane (SiH₂[NH(C₄H₉)]₂), (diisopropylamino)silane (SiH₃[N(C₃H₇)₂]), or the like may be used as the modifying agent.

One or more of these silicon (Si)-containing substances may be used as the modifying agent.

Processing conditions when supplying the Si-containing substance as the modifying agent in step A1 are exemplified as follows:
Processing temperature: room temperature (25 degrees C) to 500 degrees C, particularly room temperature to 250 degrees C;
Processing pressure: 5 to 1,000 Pa;
Processing time: 1 second to 120 minutes, particularly 30 seconds to 60 minutes;
Modifying agent supply flow rate: 0.001 to 3 slm, particularly 0.001 to 0.5 slm; and
Inert gas supply flow rate (for each gas supply pipe): 0 to 20 slm.

In addition, the notation of numerical ranges such as "25 to 500 degrees C" herein refers that lower and upper limits are included in that range. Therefore, for example, "25 to 500 degrees C" refers to "25 degrees C or more and 500 degrees C or less." This applies similarly to other numerical ranges. Further, the processing temperature herein refers to a temperature of the wafer 200 or a temperature inside the process chamber 201, and the processing pressure herein refers to a pressure inside the process chamber 201. Further, the processing time refers to time during which the processing is continued. Further, if 0 slm is included in the supply flow rate, 0 slm refers to a case where that substance is not supplied. These apply similarly to the following description.

Further, fluorine (F₂), nitrogen fluoride (NF₃), chlorine fluoride (ClF₃), hydrogen fluoride (HF), or the like may be used as the modifying agent. One or more of these fluorine (F)-containing substances may be used as the modifying agent.

Processing conditions when supplying the F-containing substance as the modifying agent in step A1 are exemplified as follows:
Processing temperature: room temperature (25 degrees C) to 300 degrees C, particularly room temperature to 200 degrees C;
Processing pressure: 1 to 2,000 Pa, particularly 1 to 1,000 Pa;
Processing time: 1 second to 60 minutes;
Modifying agent supply flow rate: 0.001 to 2 slm, particularly 0.001 to 0.5 slm; and
Inert gas supply flow rate (for each gas supply pipe): 0 to 20 slm.

In addition, in step A1, step A1(Si) in which the Si-containing substance is supplied as the modifying agent to the wafer 200 and step A1(F) in which the F-containing substance is supplied as the modifying agent to the wafer 200 may be performed in this order.

### [Step A2: [Formation of First Dielectric Film and Second Dielectric Film]

In this step, for the wafer 200 after forming the first adsorption inhibition layer on the surface of the second material, the following steps (first precursor supply and reactant supply) are performed. An oxidizing agent may be used as a reactant.

### [First Precursor Supply]

In this step, the valve 243a is opened to supply a first precursor to the wafer 200. At this time, the valves 243f to 243h may be opened to supply an inert gas into the process chamber 201.

By performing this step (first precursor supply) under processing conditions to be described later, an adsorption layer of the first precursor may be formed on the respective surfaces of the first and third materials, selectively with respect to the surface of the second material. The adsorption layer of the first precursor contains at least a portion of molecular structures of molecules constituting the first precursor.

After forming the adsorption layer of the first precursor, the valve 243a is closed to stop the supply of the first precursor to the wafer 200. Then, according to the above-described procedure, gaseous substances and others remaining inside the process chamber 201 are removed from the interior of the process chamber 201, and the interior of the process chamber 201 is purged with an inert gas (purging).

### [Reactant Supply]

In this step, the valve 243b is opened to supply a reactant to the wafer 200. At this time, the valves 243f to 243h may be opened to supply an inert gas into the process chamber 201.

By performing this step (reactant supply) under processing conditions to be described later, the adsorption layer of the first precursor selectively formed on the surface of each of the first and third materials may be modified. If an oxidizing agent is used as the reactant, the adsorption layer of the first precursor may be oxidized to form an oxide layer containing constituent elements of the first precursor on the surface of each of the first and third materials.

After modifying the adsorption layer of the first precursor, the valve 243b is closed to stop the supply of the reactant to the wafer 200. Then, according to the above-described procedure, gaseous substances and others remaining inside the process chamber 201 are removed from the interior of the process chamber 201, and the interior of the process chamber 201 is purged with an inert gas.

### [Performing Predetermined Number of Times]

Then, a predetermined number of cycles (n_{A} times, n_{A} is 1 or an integer of 2 or more) each including the first precursor supply and the reactant supply are performed. Thus, as illustrated in FIG. 4B, a first dielectric film may be formed on the surface of the first material and a second dielectric film may be formed on the surface of the third material, each of the first dielectric film and the second dielectric film being formed selectively with respect to the surface of the second material. If a metal-containing substance is used as the first precursor and an oxidizing agent is used as the reactant, the first dielectric film and the second dielectric film may be formed as metal oxide films such as an aluminum oxide film (AlO film), titanium oxide film (TiO film), hafnium oxide film (HfO film), zirconium oxide film (ZrO film), or the like, which are metal oxide films containing oxygen (O) with a higher electron trap density than that of a SiN film. Particularly, a high-k film may be applied as the dielectric film. In addition, by forming the first dielectric film and the second dielectric film, recesses are formed on the surface of the wafer 200, with the first dielectric film and the second dielectric film defining sidewalls of the recesses and the surface of the second material defining bottoms of the recesses.

In addition, the phrase "forming the first dielectric film on the surface of the first material and the second dielectric film on the surface of the third material, each of the first dielectric film and the second dielectric film being formed selectively with respect to the surface of the second material" does not completely exclude the formation of the first dielectric film or the second dielectric film on the surface of the second material, as described above. Therefore, for example, in the process of step A2, there is a case where a portion of the first adsorption inhibition layer may be detached, resulting in formation of a discontinuous oxide layer on a portion of the surface of the second material. Additionally, for example, as illustrated in FIG. 4B, in step A2, the first dielectric film may be formed so as to protrude toward (i.e., to poke out, to cover, or to intersect) the surface of the second material beyond a boundary between the surface of the second material and the surface of the first material. This is because, in the process of repeating the cycle of forming the first dielectric film, the first dielectric film serving as a base to itself may grow to protrude upward of the second material. Further, for example, in step A2, similar to the first dielectric film, the second dielectric film may also be formed so as to protrude toward (i.e., to poke out, to cover, or to intersect) the surface of the second material beyond a boundary between the surface of the second material and the surface of the third material.

For example, substances such as aluminum trichloride (AlCl₃), trimethylaluminum (Al(CH₃)₃), titanium tetrachloride (TiCl₄), hafnium tetrafluoride (HfF₄), tetrakisethylmethylaminohafnium (Hf[N(CH₃)(CH₂CH₃)]₄), zirconium tetrafluoride (ZrF₄), tetrakiscyclopentadienylmethylaminozirconium (Zr[N(CH₃)Cp]₄), or the like may be used as the first precursor. One or more of these substances, i.e., substances containing metal elements (organic metals or halogenated metals) such as aluminum (Al), titanium (Ti), hafnium (Hf), zirconium (Zr), or the like may be used as the first precursor.

For example, substances such as oxygen (O₂), ozone (O₃), water vapor (H₂O), nitrous oxide (N₂O), nitric oxide (NO), nitrogen dioxide (NO₂), carbon dioxide (CO₂), carbon monoxide (CO), or the like may be used as the reactant (oxidizing agent). One or more of these oxygen (O)-containing substances may be used as the reactant. In addition, to prevent rapid detachment of the first adsorption inhibition layer by the reactant, it is desirable to use a reactant with a relatively weak oxidizing power. For example, a reactant with a weaker oxidizing power than an oxidizing agent used in step C to be described later may be used. However, if it is possible to use a reactant with a strong oxidizing power such as if a modifying agent that is resistant to detachment by an oxidizing agent is used, an oxidizing agent with a relatively strong oxidizing power exemplified in step C to be described later may be used.

Processing conditions when supplying the first precursor in step A2 are exemplified as follows:
Processing temperature: room temperature (25 degrees C) to 500 degrees C, particularly 350 to 400 degrees C;
Processing pressure: 1 to 2,000 Pa, particularly 1 to 1,333 Pa;
Processing time: 1 to 180 seconds, particularly 10 to 120 seconds;
First precursor supply flow rate: 0.001 to 2 slm, particularly 0.01 to 1 slm; and
Inert gas supply flow rate (for each gas supply pipe): 0 to 20 slm.

Processing conditions when supplying the reactant in step A2 are exemplified as follows:
Processing pressure: 1 to 4,000 Pa, particularly 1 to 1,333 Pa; and
Reactant supply flow rate: 0.01 to 20 slm, particularly 0.01 to 10 slm. The other processing conditions may be similar to those during the first precursor supply.

In addition, a nitriding agent may be used as the reactant. For example, hydrogen nitrides such as ammonia (NH₃), diazene (N₂H₂), hydrazine (N₂H₄), N₃H₈, or the like may be used as the reactant. One or more of these nitrogen (N)-containing substances may be used as the reactant. If a Si-containing substance is used as the first precursor and a nitriding agent is used as the reactant, a SiN film may be formed as the first dielectric film and the second dielectric film.

### (Step C: Formation of First Substitutional Oxide Film and Second Substitutional oxide Film)

Next, step C is performed on the wafer 200 after forming the first dielectric film and the second dielectric film on the surface.

In this step, the valve 243b is opened to supply a reactant containing oxygen (i.e., oxidizing agent) to the wafer 200. At this time, the valves 243f to 243h may be opened to supply an inert gas into the process chamber 201.

By performing step C under processing conditions to be described later, it is possible to modify (oxidize) a portion of the first material, which is in contact with the interface between the first material and the first dielectric film, into a first substitutional oxide film through the first dielectric film, and to modify (oxidize) a portion of the third material, which is in contact with the interface between the third material and the second dielectric film, into a second substitutional oxide film through the second dielectric film. The first substitutional oxide film and the second substitutional oxide film are formed of, for example, a SiO film or SiON film. In addition, in step C, it is possible to further enhance properties of the first dielectric film and the second dielectric film as oxide films without compromising these properties. For example, it is possible to re-oxidize (further oxidize) the first dielectric film and the second dielectric film to remove impurities from these films, enabling these films to be densified.

In addition, step C is performed after performing step A and before performing step B, meaning that it is done in a state where no other films are present that come into contact with upper surfaces or side surfaces of the first dielectric film and the second dielectric film. Therefore, in step C, an expansion caused by modifying a portion of the first material into the first substitutional oxide film may shift the first dielectric film formed on the first substitutional oxide film. Further, an expansion caused by modifying a portion of the third material into the second substitutional oxide film may shift the second dielectric film formed on the second substitutional oxide film. In other words, step C allows for the expansion of a portion of the first material and the second material without the presence of any other films that would inhibit the shift of the first dielectric film and the second dielectric film, thereby preventing application of film stress such as compressive stress to the first dielectric film and the second dielectric film and enabling these films to be shifted (lifted) in a stress-free state.

Further, when at least one selected from the group of the first dielectric film and the second dielectric film is formed so as to protrude toward the surface of the second material in step A2 described above, the first adsorption inhibition layer is formed between the protruding portion and the surface of the second material, separating the two. Accordingly, even when a portion of the first material and the second material expands in step C, inhibition of the shift of the first dielectric film and/or the second dielectric film caused by combination (adhesion) of the protruding portion of the first dielectric film and/or the second dielectric film with the surface of the second material is prevented, thus preventing an increase in film stress.

After completing the above-described modification, the valve 243b is closed to stop the supply of the oxidizing agent into the process chamber 201. Then, according to the above-described procedure, gaseous substances and others remaining inside the process chamber 201 are removed from the interior of the process chamber 201, and the interior of the process chamber 201 is purged with an inert gas.

For example, oxygen-containing substances such as ozone (O₃), oxygen (O₂) + hydrogen (H₂), O₂ + deuterium (D₂), O₃ + H₂, O₃ + D₂, hydrogen peroxide (H₂O₂), O₂ or O₃ excited to a plasma state, or the like may be used as the oxidizing agent. One or more of these may be used as the oxidizing agent. Herein, the notation of two substances like "O₂ + H₂" indicates a mixture of O₂ and H₂. When supplying a mixture, two substances may be mixed (pre-mixed) inside a supply pipe before being supplied into the process chamber 201. Alternatively, two substances may be separately supplied into the process chamber 201 from different supply pipes and may be mixed (post-mixed) inside the process chamber 201. In addition, if processing conditions are regulated to enable the formation of the first substitutional oxide film and the second substitutional oxide film through the first dielectric film and the second dielectric film, an oxidizing agent with a relatively weak oxidizing power as exemplified in step A described above may also be used.

Processing conditions when supplying the oxidizing agent in step C are exemplified as follows:
Processing temperature: 350 to 1,000 degrees C, particularly 400 to 650 degrees C;
Processing pressure: 1 to 105,000 Pa, particularly 10 to 10,000 Pa;
Processing time: 1 to 10,000 seconds, particularly 5 to 3,600 seconds;
Oxidizing agent supply flow rate: 0.01 to 10 slm, particularly 0.1 to 5 slm; and
Inert gas supply flow rate (for each gas supply pipe): 0 to 20 slm.

### (Step B)

Next, the following steps B1 and B2 are performed on the wafer 200 after forming the first substitutional oxide film and the second substitutional oxide film.

### [Step B1: Embedding Film Formation]

In this step, the following steps (second precursor supply and reactant supply) are performed on the wafer 200. For example, an oxidizing agent may be used as a reactant. In at least one step selected from the group of the second precursor supply and the reactant supply, a catalyst may be supplied to the wafer 200. The following description is given of a case where a catalyst is supplied in both the second precursor supply step and the reactant supply step.

### [Second Precursor Supply]

In this step, the valves 243d and 243e are opened to supply a second precursor and a catalyst to the wafer 200. At this time, the valves 243f to 243h may be opened to supply an inert gas into the process chamber 201.

By performing this step (second precursor supply) under processing conditions to be described later, an adsorption layer of the second precursor may be formed inside recesses with sidewalls defined by the first dielectric film and the second dielectric film, as well as on at least a portion of the upper surface of each of the first dielectric film and the second dielectric film. The adsorption layer of the second precursor contains at least a portion of molecular structures of molecules constituting the second precursor.

After forming the adsorption layer of the second precursor, the valves 243d and 243e are closed to stop the supply of the second precursor and catalyst to the wafer 200. Then, according to the above-described procedure, gaseous substances and others remaining inside the process chamber 201 are removed from the interior of the process chamber 201, and the interior of the process chamber 201 is purged with an inert gas (purging).

### [Reactant Supply]

In this step, the valves 243b and 243e are opened to supply a reactant and a catalyst to the wafer 200. At this time, the valves 243f to 243h may be opened to supply an inert gas into the process chamber 201.

By performing this step (reactant supply) under processing conditions to be described later, the adsorption layer of the second precursor formed inside the recesses with the sidewalls defined by the first dielectric film and the second dielectric film, as well as the adsorption layer of the second precursor formed on at least a portion of the upper surface of each of the first dielectric film and the second dielectric film may be modified, respectively. If an oxidizing agent is used as the reactant, the adsorption layer of the second precursor may be oxidized, forming an oxide layer containing constituent elements of the second precursor inside the recesses with the sidewalls defined by the first dielectric film and the second dielectric film, as well as on at least a portion of the upper surface of each of the first dielectric film and the second dielectric film.

After modifying the adsorption layer of the second precursor, the valves 243b and 243e are closed to stop the supply of the reactant and catalyst to the wafer 200. Then, according to the above-described procedure, gaseous substances and others remaining inside the process chamber 201 are removed from the interior of the process chamber 201, and the interior of the process chamber 201 is purged with an inert gas.

### [Performing Predetermined Number of Times]

Then, a predetermined number of cycles (n_{B} times, n_{B} is 1 or an integer of 2 or more) each including the second precursor supply and the reactant supply are performed. Thus, as illustrated in FIG. 4D, an embedding layer may be formed in the recesses with the sidewalls defined by the first dielectric film and the second dielectric film, as well as on at least a portion of the upper surface of each of the first dielectric film and the second dielectric film. This cycle is executed until the recesses are filled by the embedding film. If a Si-containing substance is used as the second precursor and an oxidizing agent is used as the reactant, an oxide film, for example, a silicon oxide film (SiO film), may be formed as the embedding film.

For example, alkylaminosilanes or aminosilanes as mentioned above may be used as the second precursor. Further, chlorosilanes such as dichlorosilane (SiH₂Cl₂), tetrachlorosilane (SiCl₄), hexachlorodisilane (Si₂Cl₆), octachlorotrisilane (Si₃Cl₈), or the like may be used as the second precursor. One or more of these Si-containing substances may be used as the second precursor.

One or more of the aforementioned O-containing substances may be used as the reactant (oxidizing agent).

For example, amines such as pyridine (C₅H₅N), picoline (C₆H₇N), lutidine (C₇H₉N), triethylamine ((C₂H₅)₃N), or the like may be used as the catalyst. One or more of these amines may be used as the catalyst.

Processing conditions when supplying the second precursor and the catalyst in step B1 are exemplified as follows:
Processing temperature: room temperature (25 degrees C) to 200 degrees C, particularly room temperature to 150 degrees C;
Processing pressure: 1 to 2,000 Pa, particularly 1 to 1,333 Pa;
Processing time: 1 to 180 seconds, particularly 10 to 120 seconds;
Second precursor supply flow rate: 0.001 to 2 slm, particularly 0.01 to 1 slm; and
Catalyst supply flow rate: 0.001 to 2 slm, particularly 0.01 to 1 slm.

Processing conditions when supplying the reactant and the catalyst in step B1 are exemplified as follows:
Processing pressure: 1 to 4,000 Pa, particularly 1 to 1,333 Pa;
Reactant supply flow rate: 0.001 to 2 slm, particularly 0.01 to 1 slm; and
Catalyst supply flow rate: 0.001 to 2 slm, particularly 0.01 to 1 slm.

The other processing conditions may be similar to those during the second precursor supply and catalyst supply.

After the formation of the embedding film on the surface of the wafer 200 is completed, the interior of the process chamber 201 is purged to remove any gases, reaction by-products, or the like remaining inside the process chamber 201 (after-purge). Thereafter, an atmosphere inside the process chamber 201 is replaced with an inert gas (inert gas replacement), and the pressure inside the process chamber 201 is returned to normal pressure (atmospheric pressure recovery). Thereafter, the processed wafer 200 is unloaded to an outside of the reaction tube 203 (boat unloading) and is then taken out from the boat 217 (wafer discharge). In addition, following boat unloading, the opening at the lower end of the manifold 209 is sealed by the shutter 219s (shutter closing).

### [Step B2: Separation Film Formation]

Next, step B2 is performed on the wafer 200 after wafer discharge, i.e., the wafer 200 after forming the embedding film on the surface.

In step B2, a portion of the embedding film formed on the surface of the wafer 200 that is inside the recesses is left as a separation film, while the other portion is removed so that at least a portion of the first dielectric film and the second dielectric film is exposed. The partial removal of the embedding film may be accomplished, for example, by anisotropic etching using a plasma-excited etching gas such as a fluorocarbon (CF)-based gas. Anisotropic etching may be performed, for example, by using the above-described etching unit such as a plasma etching device under known processing procedures and processing conditions. As for CF gases, for example, one or more of CF₄, C₄F₆, C₄F₈, CH₂F₂, CHF₃ gases, and the like may be used. In addition, the partial removal of the embedding film is not limited to a case where it is performed by anisotropic etching. When the above-described adjacent structure is provided on a flat portion of the surface of the wafer 200, the partial removal of the embedding film may also be performed, for example, by chemical mechanical polishing (CMP).

By performing step B2, as illustrated in FIG. 4E, the surface of the wafer 200 is in a state where the first dielectric film, the separation film, and the second dielectric film are exposed adjacent to each other in this order. The first dielectric film and the second dielectric film are physically and electrically separated (isolated) by the separation film therebetween. If the partial removal of the embedding film is performed by anisotropic etching or CMP as described above, it is possible to make entire exposed surfaces of the first dielectric film, separation film, and second dielectric film into adjacent smooth surfaces (flat surfaces or curved surfaces) without any steps.

### (Step D: Formation of Tunnel Oxide Film and Channel Film)

Next, step D is performed on the wafer 200 after forming the first substitutional oxide film and the second substitutional oxide film.

In this step, a tunnel oxide film and a channel film are sequentially stacked on the surface of each of the separation film, the first dielectric film, and the second dielectric film formed on the wafer 200. The formation of the tunnel oxide film and the channel film may be performed by known methods commonly used in manufacturing processes of a portion of memory cells in a flash memory. In addition, step D may be performed either inside the above-described process chamber 201 where steps A1, A2, C and B1 are performed, or inside a process chamber of another substrate processing apparatus.

Through the execution of steps A to D, a stacked structure illustrated in FIG. 4F is manufactured.

This stacked structure may be suitably used, for example, as a portion of components of memory cells in a flash memory. In other words, each of the first dielectric film and the second dielectric film may be suitably used as charge trap layers of the memory cells since the first dielectric film and the second dielectric film formed by the above-described method are made of metal oxide films, providing a higher electron trap density than SiN films, and these films are precisely formed with high dimensional accuracy to achieve an appropriate shape. Further, the separation film is made of an oxide film such as a SiO film and the like, and thus may be suitably used as an insulating separation layer between adjacent charge trap layers of memory cells in a flash memory. Furthermore, since the first substitutional oxide film and the second substitutional oxide film are made of oxide films (SiO films or SiON films), they may be suitably used, respectively, as blocking layers that prevent carrier leakage from the charge trap layers.

### (3) Effects of Present Embodiments

According to the present embodiments, one or more of the following effects are obtained.
(a) According to the present embodiments, it is possible to precisely form a film on a substrate. In other words, in the above-described step A, in the substrate including the above-described structure in which the respective surfaces of the first to third materials are adjacent to each other, it is possible to selectively form dielectric films (first dielectric film and second dielectric film) on a surface of a base made of specific materials (first material and third material). These dielectric films formed may be suitably used, for example, as charge trap layers of memory cells in a flash memory. Further, in the above-described step B, it is possible to form a separation film between these dielectric films. The separation film formed may be suitably used, for example, as an isolator (separator) that separates adjacent charge trap layers of memory cells in a flash memory.
(b) The above-described effects are more reliably obtained when the above-described materials are used as the first to third materials. For example, with the first to third materials being formed of the materials described above, the first dielectric film and the second dielectric film may be selectively formed on the surface of the first material and the surface of the third material, respectively, by utilizing OH-terminals (hydroxyl-group terminals) selectively formed on the surface of the second material, which is an oxide. Further, with the first to third materials being formed of the materials described above, a structure in which the first to third materials are adjacent in this order may be suitably used, for example, as a portion of components of memory cells in a flash memory.
(c) The above-described effects are more reliably obtained when an oxide film such as a SiO film and the like is used as the separation film. Further, since the separation film is an oxide film such as a SiO film and the like, this film may be suitably used, for example, as an insulating separation layer between adjacent charge trap layers of memory cells in a flash memory.
(d) Since each of the first dielectric film and the second dielectric film is an oxide film such as a metal oxide film and the like, each of the first dielectric film and the second dielectric film may be suitably used, for example, as a charge trap layer of a memory cell.

Further, since each of the first dielectric film and the second dielectric film is an oxide film such as a metal oxide film and the like, even if oxidation (modification) of a portion of the first material or a portion of the third material is performed through the first dielectric film or the second dielectric film when forming the first substitutional oxide film or the second substitutional oxide film in step C, properties of these dielectric films as oxide films may be maintained. In contrast, for example, if the first dielectric film or the second dielectric film is a nitride film, oxidation of a portion of the first material or a portion of the third material through the first dielectric film or the second dielectric film may cause at least a portion of nitrogen in the film to dissociate, making it difficult to maintain properties of these films as nitride films.

In addition, since each of the first dielectric film and the second dielectric film possesses a higher electron trap density than silicon nitride films, these films may be suitably used, for example, as charge trap layers of memory cells.

(e) In step A, by performing steps A1 and A2 described above, it is possible to selectively and efficiently form both the first dielectric film and the second dielectric film, with respect to the surface of the second material.

(f) In step A, by forming the first dielectric film so as to protrude toward the surface of the second material beyond the boundary between the surface of the second material and the surface of the first material, and by forming the second dielectric film so as to protrude toward the surface of the second material beyond the boundary between the surface of the second material and the surface of the third material, these films may be given an optimal shape and size for use as charge trap layers of memory cells. For example, shaping the films in this manner makes it easier to secure a sufficient area for charge trap layers of memory cells.

(g) After step A, by performing step C in which an oxidizing agent is supplied to the wafer 200, it is possible to form the first substitutional oxide film or the second substitutional oxide film, which is an oxide film with high insulation properties, adjacent to the first dielectric film or the second dielectric film. Further, by performing modification (oxidation) through the first dielectric film or the second dielectric film, it is possible to improve film quality of the first dielectric film or the second dielectric film, thereby making these films more suitable, for example, as charge trap layers of memory cells.

(h) In step C, due to the expansion caused by a portion of the first material being modified into the first substitutional oxide film, the first dielectric film may be shifted (lifted). Similarly, due to the expansion caused by a portion of the third material being modified into the second substitutional oxide film, the second dielectric film may be shifted (lifted). In other words, in step C, both the first dielectric film and the second dielectric film may be lifted without compressing each of them. Thus, it is possible to avoid degradation in quality of each of the first dielectric film and the second dielectric film. In addition, by performing step C before performing step B, i.e., before forming the separation film, the effects described herein may be more reliably obtained.

(i) When performing steps B1 and B2 in step B, it is possible to form the separation film with good controllability and high dimensional accuracy by using recesses, with the sidewalls defined by the first dielectric film and the second dielectric film, as a framework. Further, by covering at least a portion of the upper surface of each of the first dielectric film and the second dielectric film with the embedding film in step B 1, and then removing an unwanted portion of the embedding film in step B2, it is possible to create the separation film that fills the recesses without voids or gaps. This allows the separation film to be suitably used, for example, as an insulating separation layer between adjacent charge trap layers.

Further, in step B1, by performing a predetermined number of cycles each including the second precursor supply and the reactant supply, it is possible to form the embedding film with good step coverage and good controllability. This improves quality of the separation film, making it suitable for use, for example, as a separation film for charge trap layers.

(j) Since the respective surfaces of the first material, the second material, and the third material are aligned on the same plane, the stacked structure obtained by performing steps A and B may be suitably used, for example, as a portion of components of memory cells in a flash memory.

(k) By using the first dielectric film and the second dielectric film formed by the method of the present disclosure as films constituting, for example, charge trap layers of memory cells, it is possible to improve performance of a flash memory device.

(l) The above-described effects may be achieved even when arbitrarily selecting and using predetermined substances from various modifying agents, various precursors, various reactants (oxidizing agents), and various inert gases described above.

### <Other Embodiments of Present Disclosure>

The embodiments of the present disclosure are specifically described above. However, the present disclosure is not limited to the above-described embodiments and may be changed in various ways without departing from the gist of the present disclosure.

For example, after performing step A, step B may be performed without performing step C. In this case, in step B, by supplying a second precursor and an oxidizing agent to the wafer 200, in addition to the formation of the separation film, a portion of the first material in contact with the interface between the first material and the first dielectric film may be modified into the first substitutional oxide film through the first dielectric film, and further, a portion of the third material in contact with the interface between the third material and the second dielectric film may be modified into the second substitutional oxide film through the second dielectric film. In step B 1, by using an oxidizing agent with strong oxidizing power exemplified in step C (such as O₃, O₂ + H₂, O₂ + D₂, O₃ + H₂, O₃ + D₂, H₂O₂, O₂ or O₃ excited to a plasma state, etc.), as described herein, it is possible to simultaneously perform the formation of the separation film, the modification of a portion of the first material into the first substitutional oxide film, and the modification of a portion of the third material into the second substitutional oxide film, thereby improving productivity of devices.

Further, for example, in step B, for the wafer 200 after forming the first dielectric film and the second dielectric film on the surface, the following steps may be performed:
(b-1) step B1' in which a second adsorption inhibition layer (second inhibitor layer) that inhibits adsorption of the second precursor is formed on the surfaces of the first dielectric film and the second dielectric film, selectively with respect to the surface of the second material; and
(b-2) step B2' in which the second precursor is supplied to the wafer 200, thereby forming the separation film on the surface of the second material, selectively with respect to the surfaces of the first dielectric film and the second dielectric film.

Processing sequences and processing conditions in step B1' may be similar to, for example, those in the above-described step A1 (formation of the first adsorption inhibition layer). Processing procedures and processing conditions in step B2' may be similar to, for example, those in the above-described step B1 (formation of the embedding film).

In this case as well, the same effects as in the above-described embodiments are obtained. Further, this approach allows for the efficient and selective formation of the separation film on the surface of the second material, with respect to the surfaces of the first dielectric film and the second dielectric film. Further, the implementation of step B2 for removing the unwanted embedding film after forming the separation film may be omitted, thereby improving the productivity of devices.

In addition, when performing steps B1' and B2' in step B, it is desirable for step B2' to continue until the recesses are filled with the separation film. By ensuring that the recesses are filled without gaps by the separation film, this film may be suitably used as a separator layer that provides insulation between adjacent charge trap layers of memory cells in a flash memory.

It is desirable to prepare recipes used for each processing individually based on processing contents and to record and store them in the memory 121c via an electrical communication line or the external memory 123. Also, when initiating each processing, it is desirable for the CPU 121a to appropriately select a suitable recipe from among multiple recipes recorded and stored in the memory 121c based on the processing contents. This allows for formation of films of various film types, compositions, film qualities, and film thicknesses with high reproducibility in a processing apparatus. Further, this reduces the burden on operators, thereby avoiding operational errors and enabling quick initiation of each processing.

The aforementioned recipes are not limited to newly prepared ones but may also be prepared, for example, by modifying existing recipes already installed in the processing apparatus. When modifying recipes, the modified recipes may be installed in the processing apparatus via an electrical communication line or a recording medium in which these recipes are recorded. Further, existing recipes already installed in the processing apparatus may be directly modified by operating the input/output device 122 provided in the existing processing apparatus.

In the above-described embodiments, an example of performing film formation by using a batch-type processing apparatus capable of processing multiple substrates at once is described. The present disclosure is not limited to the above-described embodiments, and for example, may be suitably applied even when performing film formation by using a single-substrate type processing apparatus capable of processing one or several substrates at once. Further, in the above-described embodiments, an example where film formation is performed by using a processing apparatus equipped with a hot-wall type process furnace is described. The present disclosure is not limited to the above-described embodiments, and may also be suitably applied when performing film formation by using a processing apparatus equipped with a cold-wall type process furnace.

Further, in the above-described embodiments, an example where a series of process sequences including steps A1, A2, C and B1 is performed successively in a same process chamber of a same processing apparatus (in-situ) is described. The present disclosure is not limited to the above-described embodiments. One step and another step among steps A1, A2, C and B1 may be performed in different process chambers of different processing apparatuses (ex-situ), or may be performed in different process chambers of a same processing apparatus.

Even when using such processing apparatuses, it is possible to perform each processing by using the same processing procedures and processing conditions in the above-described embodiments and modifications, and to achieve the same effects as the above-described embodiments and modifications.

The above-described embodiments and modifications may be used in combination as appropriate. The processing procedures and processing conditions at this time may be the same as those of the above-described embodiments and modifications, for example.

According to the present disclosure in some embodiments, it is possible to precisely form a film on a substrate.

While certain embodiments are described, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate (200), comprising:
(a) in the substrate (200) including a structure where respective surfaces of a first material, a second material, and a third material are adjacent to each other in this order, forming a first dielectric film containing oxygen on the surface of the first material and a second dielectric film containing oxygen on the surface of the third material, each of the first dielectric film and the second dielectric film being formed selectively with respect to the surface of the second material; and
(b) forming a separation film inside a recess with a sidewall defined by the first dielectric film and the second dielectric film.

2. The method of Claim 1, wherein the second material is an oxide, and each of the first material and the third material is at least one selected from the group of an oxide with a lower oxygen content ratio than an oxygen content ratio of the second material and a non-oxide.

3. The method of Claim 1, wherein each of the first material and the third material is a nitride, and the second material is an oxide.

4. The method of any one of Claims 1 to 3, wherein the separation film is an oxide film.

5. The method of any one of Claims 1 to 4, wherein each of the first dielectric film and the second dielectric film is a metal oxide film.

6. The method of any one of Claims 1 to 5, wherein (a) includes:
(a-1) forming a first adsorption inhibition layer that inhibits adsorption of a first precursor on the surface of the second material, selectively with respect to each of the surface of the first material and the surface of the third material; and
(a-2) supplying the first precursor to the substrate (200), thus forming the first dielectric film on the surface of the first material and the second dielectric film on the surface of the third material, respectively.

7. The method of any one of Claims 1 to 6, wherein in (a), the first dielectric film is formed so as to protrude toward the surface of the second material beyond a boundary between the surface of the second material and the surface of the first material.

8. The method of any one of Claims 1 to 7, further comprising:
(c) after (a), modifying a portion of the first material in contact with an interface between the first material and the first dielectric film into a first substitutional oxide film through the first dielectric film by supplying an oxidizing agent to the substrate (200).

9. The method of Claim 8, wherein in (c), the first dielectric film is shifted due to an expansion caused by modification of the portion of the first material into the first substitutional oxide film.

10. The method of any one of Claims 1 to 7, wherein in (b), by supplying a second precursor and an oxidizing agent to the substrate (200), in addition to the forming the separation film, a portion of the first material in contact with an interface between the first material and the first dielectric film is modified into a first substitutional oxide film through the first dielectric film.

11. The method of any one of Claims 1 to 10, wherein (b) includes:
(b-1) forming an embedding film that fills the recess and covers at least a portion of an upper surface of each of the first dielectric film and the second dielectric film; and
(b-2) leaving a portion of the embedding film formed inside the recess as the separation film while removing a remaining portion.

12. The method of any one of Claims 1 to 10, wherein (b) includes:
(b-1) selectively forming a second adsorption inhibition layer that inhibits adsorption of a second precursor on the surface of the first dielectric film and the surface of the second dielectric film, with respect to the surface of the second material; and
(b-2) supplying the second precursor to the substrate (200), thus forming the separation film on the surface of the second material, selectively with respect to the surface of the first dielectric film and the surface of the second dielectric film.

13. A method of manufacturing a semiconductor device comprising the method of Claim 1.

14. A program that causes, by a computer, a substrate processing apparatus to execute a process comprising:
(a) in a substrate (200) including a structure where respective surfaces of a first material, a second material, and a third material are adjacent to each other in this order, forming a first dielectric film containing oxygen on the surface of the first material and a second dielectric film containing oxygen on the surface of the third material, each of the first dielectric film and the second dielectric film being formed selectively with respect to the surface of the second material; and
(b) forming a separation film inside a recess with a sidewall defined by the first dielectric film and the second dielectric film.

15. A substrate processing apparatus used in the method of Claim 1, the substrate processing apparatus comprising:
a first precursor supply system configured to supply a first precursor to the substrate (200); and
a controller (121) configured to be capable of controlling the first precursor supply system so as to execute a process of forming the first dielectric film on the surface of the first material and the second dielectric film on the surface of the third material, respectively, by supplying the first precursor to the substrate (200).
